# EUROPEAN PATENT APPLICATION

(11) **EP 4 047 061 A1**
(43) Date of publication of application: **24.08.2022**
(21) Application number: 20877114.7
(22) Date of filing: 15.10.2020
(51) Int. Cl.: C09D 5/24, C09D 11/52, H01B 1/20, H01B 5/14, H01B 5/16, H01B 13/00, C09D 7/61, C09D 7/63

(54) **CONDUCTIVE FILM, DISPERSION, MANUFACTURING METHODS FOR THESE, AND DEVICE INCLUDING CONDUCTIVE FILM**

(30) Priority: 15.10.2019 JP 2019188983
(71) Applicant: Kyoto University, Kyoto-shi, Kyoto 606-8501 (JP)
(72) Inventor: SAKAMOTO, Masanori, Kyoto-shi, Kyoto 606-8501 (JP)
(74) Representative: Cabinet Beau de Loménie
(86) International application number: PCT/JP2020/038907
(87) International publication number: WO 2021/075495

(57) **Abstract**

Provided is a conductive film that can be formed without using a vacuum deposition method and includes a material that is neither a noble metal nor a special carbon material as a conductive element for exhibiting conductivity. The conductive film provided includes an arrangement portion of semiconductor nanoparticles. When a cross section including the arrangement portion is observed, the semiconductor nanoparticles are arranged in line apart from each other in the arrangement portion. A conductivity C1 measured along at least one direction is 7 S/cm or more.

## Description

### TECHNICAL FIELD

The present invention relates to a conductive film, particularly a light-transmissive conductive film. The present invention also relates to a method for manufacturing a conductive film, a dispersion for manufacturing a conductive film, and a method for manufacturing a dispersion, and further to a device including a conductive film.

### BACKGROUND ART

Conductive films, particularly transparent conductive films having high light-transmittance are used as electrodes, antistatic films, and the like in various devices. Industrial mass production of conductive films is often performed by vacuum deposition methods typified by a sputtering method.

The vacuum deposition methods require a large-scale equipment because of the necessity for a reduced-pressure atmosphere and appropriate substrates are also limited. In view of such problems, conductive films including silver nanowires (e.g., Patent Literature 1 and Non Patent Literature 1), conductive films including carbon nanotubes (e.g., Patent Literature 2), and the like have been proposed. These conductive films can be formed by a printing method, a coating method, or the like that requires no reduced-pressure atmosphere.

### CITATION LIST

### Patent Literature

Patent Literature 1: JP 2017-92036 A
Patent Literature 2: WO 2015/115102

### Non Patent Literature

Non Patent Literature 1: NAKAZAWA Eri et al., "Transparent Conductive Electrode Technology of Silver Nanowires", Journal of Smart Processing, Smart Processing Society for Materials, Environment & Energy, 2015, Vol. 4, No. 4, pp. 202-206

### SUMMARY OF INVENTION

### Technical Problem

However, it is not easy to reduce manufacturing costs of elemental noble metals, such as silver nanowires, and special carbon materials, such as carbon nanotubes. An object of the present invention is to provide a conductive film that can be formed without applying a vacuum deposition method and includes a material that is neither noble metal nor special carbon material as a conductive element for exhibiting conductivity. Another object of the present invention is to provide a method and a dispersion for manufacturing such a conductive film, a method for manufacturing a dispersion, and even a device including such a conductive film.

### Solution to Problem

It has been considered that the presence of a conductive path formed of conductive elements in contact with each other in a film is essential for exhibition of practical conductivity. However, according to the studies by the present inventor, unexpectedly high conductivity can be exhibited also from a film including semiconductor nanoparticles that are apart from each other.

That is, the present invention provides a conductive film including
an arrangement portion of semiconductor nanoparticles, wherein
the semiconductor nanoparticles are arranged in line apart from each other in the arrangement portion in a cross section of the conductive film, the cross section including the arrangement portion, and
a conductivity C1 measured along at least one direction is 7 S/cm or more.

The conductivity required for conductive films may be practically sufficient as long as it is achieved for a specific direction. From this viewpoint, conductive films do not necessarily need to exhibit high conductivity for all directions. Based on this idea, a highly useful conductive film including semiconductor nanoparticles as conductive elements can be achieved.

That is, the present invention provides, in another aspect thereof, a conductive film including semiconductor nanoparticles as conductive elements, wherein
the conductive film exhibits an anisotropic conductivity in which a conductivity C1 measured along a first direction is 7 S/cm or more and a conductivity C2 measured along a second direction is less than 10% of the conductivity C1, and
one of the first direction and the second direction is a film surface direction, and the other is a film thickness direction.

Further, the present invention provides a dispersion suitable for manufacturing the conductive film described above.

That is, the present invention provides, in another aspect thereof, a dispersion including:
a dispersion medium;
semiconductor nanoparticles dispersed in the dispersion medium; and
a first compound, wherein
the first compound is present as an adhered compound and a free compound, the adhered compound adhering to the semiconductor nanoparticles, the free compound being freed from the semiconductor nanoparticles, and
the dispersion satisfies at least one selected from i) to iv):
   i) a ratio of an amount of the first compound present as the free compound to an amount of the first compound present as the adhered compound is 1 or more;
   ii) a proportion of an amount of the first compound to a sum of amounts of the semiconductor nanoparticles and the first compound is 10% or more in terms of mass;
   iii) the semiconductor nanoparticles include at least one selected from an oxide, a sulfide, a selenide, and a telluride; and
   iv) the semiconductor nanoparticles are each a columnar body and/or a polyhedron.

Further, the present invention provides a method for manufacturing the dispersion according to the present invention. This manufacturing method is a manufacturing method including:
mixing a starting liquid and a solvent to obtain a liquid mixture, the starting liquid including a dispersion medium, semiconductor nanoparticles dispersed in the dispersion medium, a first compound, and an impurity;
applying a centrifugal operation to the liquid mixture at a rotation speed of less than 5000 rpm; and
removing, after the centrifugal operation, the solvent together with at least a portion of the impurity from the liquid mixture.

Further, the present invention provides, in another aspect thereof, an ink set including:
a first ink being a dispersion and including a dispersion medium, semiconductor nanoparticles dispersed in the dispersion medium, and a first compound, the first compound being present as an adhered compound and a free compound, the adhered compound adhering to the semiconductor nanoparticles, the free compound being freed from the semiconductor nanoparticles; and
a second ink including a second compound having a lower molecular weight than the first compound, the second compound being adherable to the semiconductor nanoparticles as a substitution of the first compound.

Further, the present invention provides, in another aspect thereof, a device including the conductive film according to the present invention, wherein
the device includes the conductive film as at least one functional film selected from an electrode film, an antistatic film, a heat-generating film, and an electromagnetic shielding film.

The present invention provides, in another aspect thereof, a device including:
a conductive film including semiconductor nanoparticles; and
at least one electrode in contact with the conductive film, wherein
the conductive film satisfies the following a) and/or b):
   a) the conductive film includes an arrangement portion of the semiconductor nanoparticles,
      the semiconductor nanoparticles are arranged in line apart from each other in the arrangement portion in a cross section of the conductive film, the cross section including the arrangement potion, and
      a conductivity C1 measured along at least one direction is 7 S/cm or more; and
   b) the conductive film includes the semiconductor nanoparticles as conductive elements,
      the conductive elements exhibit an anisotropic conductivity in which a conductivity C1 measured along a first direction is 7 S/cm or more and a conductivity C2 measured along a second direction is less than 10% of the conductivity C1, and
      one of the first direction and the second direction is a film surface direction, and the other is a film thickness direction.

The present invention provides, in another aspect thereof, a method for manufacturing the conductive film according to the present invention. This manufacturing method is a method for manufacturing the conductive film, including:
a first step of applying a first ink to a surface of a base to form a coating film, the first ink being a dispersion and including a dispersion medium, semiconductor nanoparticles dispersed in the dispersion medium, and a first compound, the first compound being present as an adhered compound and a free compound, the adhered compound adhering to the semiconductor nanoparticles, the free compound being freed from the semiconductor nanoparticles; and
a second step of bringing, into contact with the coating film, a second ink including a second compound that is adherable to the semiconductor nanoparticles as a substitution of the first compound, to substitute the second compound for at least a portion of the first compound in the coating film, the second compound having a lower molecular weight than the first compound.

### Advantageous Effects of Invention

The conductive film according to the present invention can be formed by a method other than a vacuum deposition method, specifically, for example, by a coating method, and uses semiconductor nanoparticles as conductive elements for exhibiting conductivity. Therefore, the conductive film can be formed on a wide range of substrates, and is more advantageous from the viewpoint of manufacturing cost reduction than films using of elemental noble metal or special elemental carbon as a conductive element.

### BRIEF DESCRIPTION OF DRAWINGS

FIG. 1 is a cross-sectional view showing an example of a conductive film.
FIG. 2 is a view showing an example of the shape and the arrangement of semiconductor nanoparticles included in the conductive film.
FIG. 3 is a view showing another example of the shape and the arrangement of the semiconductor nanoparticles included in the conductive film.
FIG. 4 is a view showing yet another example of the shape and the arrangement of the semiconductor nanoparticles included in the conductive film.
FIG. 5 is a cross-sectional view showing an example of a device including the conductive film.
FIG. 6 is a cross-sectional view showing another example of the device including the conductive film.
FIG. 7 is a diagram showing an example of the light transmittance.
FIG. 8 is an example of an image obtained by observing the conductive film with a transmission electron microscope (TEM).
FIG. 9 is another example of the image obtained by observing the conductive film by the TEM.
FIG. 10 is a view for describing a bending test.
FIG. 11 is a view showing an example of the change in resistivity of the conductive film by the bending test.

### DESCRIPTION OF EMBODIMENTS

Hereinafter, embodiments of the present invention will be described with reference to the drawings as appropriate. The following description is not intended to limit the present invention to specific embodiments. The term "semiconductor" is used herein to include not only general semiconductors but also semimetals. Semimetals are materials having a band structure in which the bottom of the conduction band and the top of the valence band slightly overlap each other over the Fermi level due to a distortion of the crystal structure, an interaction between layers of crystals, or the like. The term "nanoparticles" means particles having the minimum particle diameter of less than 1 µm, for example, in the range from 0.1 nm to less than 1 µm. Nanoparticles typically mean particles having the maximum particle dimension of 5 µm or less or even in the range from 3 nm to 2 µm. Note that the "minimum diameter" is determined by the minimum dimension passing through the center of gravity of the particle, and the "maximum dimension" is determined by the longest line segment that can be set in the particle. In addition, the term "substantially parallel" is used to intend to limit the difference in direction to 10° or less, particularly 5° or less. The terms "autonomously arranged" and "autonomous arrangement" are used to mean that semiconductor nanoparticles are arranged in a self-organizing manner using an interaction between the particles as a driving force. The term "functional group" is used as a term that includes halogen atoms.

### <Conductive Film>

The conductive film of the present embodiment includes semiconductor nanoparticles as conductive elements. The conductive film includes an arrangement portion of the semiconductor nanoparticles. When a cross section including the arrangement portion is observed, the semiconductor nanoparticles are arranged apart from each other in the arrangement portion. The semiconductor nanoparticles may be arranged in line in the arrangement portion. The conductive film may include a plurality of arrangement portions extending substantially parallel to each other, or may include a plurality of arrangement portions intersecting each other or connecting to each other at their end portions. The conductive film may include, in at least one cross section thereof, an arrangement portion in which semiconductor nanoparticles are arranged in line apart from each other.

A conductivity C1 measured along at least one direction of the conductive film is 7 S/cm or more. When the direction along which the conductivity C1 is measured is defined as a first direction, a conductivity C2 measured along a second direction different from the first direction may be, for example, less than 10%, particularly less than 1% of the conductivity C1 (that is, C2/C1 < 0.1, particularly C2/C1 < 0.01). The first direction and the second direction may be orthogonal to each other. One of the features of the conductive film of the present embodiment lies in the anisotropy of the conductivity. Here, for example, one of the first direction and the second direction is a direction parallel to the film surface, that is, the film surface direction, and the other is a direction perpendicular to the film surface, that is, the film thickness direction. The lower limit of the conductivity C2 is not particularly limited, and is, for example, 2 × 10⁻⁵ S/cm or more.

In the cross section in which the arrangement portion of the semiconductor nanoparticles is observed, the average spacing between adjacent semiconductor nanoparticles is preferably 10 nm or less. The "average spacing" between semiconductor nanoparticles is determined by measuring the shortest distance between each adjacent two particles apart from each other in the arrangement portion of the semiconductor nanoparticles appearing in the film cross section, and calculating the arithmetic average of them. In one example, the average distance can be determined by measuring the shortest distance between adjacent two particles apart from each other at 10 points along a portion where the two particles face each other and calculating the arithmetic average of them (so-called ten-point average). In the arrangement portion in the above cross section, the semiconductor nanoparticles that are adjacent to each other are preferably apart from each other such that opposite sides of the adjacent semiconductor nanoparticles are substantially parallel to each other. In the conductive film, the first direction in which the conductivity C1 of 7 S/cm or more is obtained may be parallel to the cross section in which the above-described arrangement portion appears. The arrangement portion may be formed by an autonomous arrangement of the semiconductor nanoparticles in film formation of the conductive film.

The conductive film may include a compound adhering to the semiconductor nanoparticles, that is, an adhered compound. The adhered compound is a compound different from a semiconductor constituting the semiconductor nanoparticles, typically an organic or inorganic compound that is not a semiconductor, and is preferably a compound different from an adhered material for protecting semiconductor nanoparticles included in a conductive ink that is a dispersion of the semiconductor nanoparticles against aggregation. The molecular weight of the adhered compound is preferably 300 or less, 200 or less, 150 or less, more preferably less than 110, and particularly preferably less than 60. The adhered compound may have a functional group suitable for bonding with the semiconductor nanoparticles, for example, a ligand that can bond to a metal atom by a coordinate bond. This functional group may be included as an ion constituting a salt. In this case, the molecular weight of this compound is calculated excluding the counter ion of the salt. Accordingly, for example, the molecular weight of KSCN including SCN that can adhere to the semiconductor nanoparticles is calculated excluding K, resulting in 58.1.

The three-dimensional shape of the semiconductor nanoparticles may be a columnar body and/or a polyhedron. The bottom surface of the columnar body is not particularly limited, and is, for example, a circle, an ellipse, or a polygon. The columnar body is typically a column whose both bottom surfaces are identical and parallel to each other. However, the columnar body is not limited to this, and is, for example, a three-dimensional body whose longitudinal section cut along a plane passing through the both bottom surfaces is a quadrilateral or can be regarded as a quadrilateral. The polyhedron may be a regular polyhedron such as a regular hexahedron, but is not limited to this. One preferred three-dimensional shape is a rod-shaped columnar body, in which when the bottom surface is regarded as a circle having the same area, the height is two times or more, even three times or more, or particularly four times or more the diameter of the circle (hereinafter, such a shape is simply referred to as "rod-shaped" or "rod shape"). However, the columnar body is not limited to this, and may be a disc-shaped columnar body, in which the bottom surface is regarded as a circle having the same area, the height is 1/2 times or less, even 1/3 times or less, or particularly 1/4 times or less the diameter of the circle (hereinafter, such a shape is simply referred to as "disc-shaped" or "disc shape"). The three-dimensional shape of the semiconductor nanoparticles may be a rod-shape and/or a disc-shape.

The semiconductor nanoparticles may include at least one selected from an oxide, a sulfide, a selenide, and a telluride, may include at least one selected from a sulfide, a selenide, and a telluride, or may be a sulfide and/or a selenide. However, for use applications for example requiring the durability such as the heat resistance, semiconductor nanoparticles including an oxide are suitable in general.

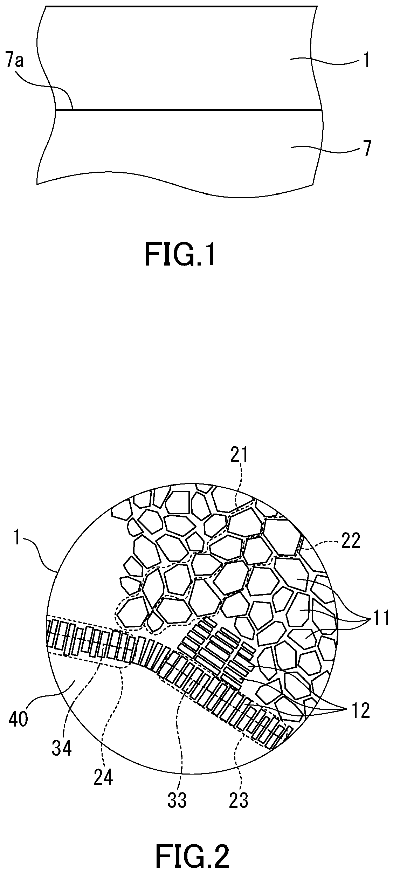

FIG. 1 shows an example of the conductive film. A conductive film 1 is formed on a surface 7a of a base 7. FIG. 1 is a film cross section obtained when the conductive film 1 is cut along a direction perpendicular to the surface 7a. FIG. 2 shows semiconductor nanoparticles 11 and 12 included in the conductive film 1. The aspect of the shape and the arrangement of the semiconductor nanoparticles 11 and 12 such as shown in FIG. 2 can be observed using, for example, a TEM. The minimum diameter of the semiconductor nanoparticles 11 and 12 is less than 1 µm, for example, 500 nm or less, and is preferably 100 nm or less. In the present embodiment, an insulating material is present in a matrix 40 where the semiconductor nanoparticles 11 and 12 are not present.

In the film cross section of the conductive film 1 shown in FIG. 2, the semiconductor nanoparticles 11 and 12 appear. The semiconductor nanoparticles 11 in the film cross section are each substantially a polygon having five or more vertices, specifically a pentagon or a hexagon. The semiconductor nanoparticles 12 in the film cross section are each substantially a quadrilateral. The semiconductor nanoparticles 12 in the film cross section are each more specifically a rectangle, still more specifically a rectangle in which the long side corresponding to the bottom surface is twice or more the short side corresponding to the height. The semiconductor nanoparticles 11 and 12 thus observed are each, for example, disc-shaped. However, the shape of the semiconductor nanoparticles in the film cross section is not limited to the above, and may be a circle, an ellipse, a triangle, a quadrilateral other than a rectangle, or the like, and is, for example, a square.

In the case where the semiconductor nanoparticles 12 appearing in the film cross section are each a rectangle, the length of the long side of the rectangle is, for example, 3 to 2000 nm, even 5 to 900 nm, or even 10 to 50 nm. The length of the short side of the semiconductor nanoparticles 12 is, for example, 2 to 100 nm or even 3 to 20 nm. The ratio in length of the long side to the short side of the semiconductor nanoparticles 12 may be, for example, 2 or more.

The conductive film 1 includes arrangement portions 21 and 22 in which the semiconductor nanoparticles 11 are arranged and arrangement portions 23 and 24 in which the semiconductor nanoparticles 12 are arranged. In the arrangement portions 21 to 24, the semiconductor nanoparticles are arranged in line out of contact with adjacent particles. In the arrangement portions 21 and 22, the semiconductor nanoparticles 11 that are substantially pentagonal or hexagonal are arranged. In the arrangement portions 23 and 24, the semiconductor nanoparticles 12 that are substantially rectangular are arranged. The number of semiconductor nanoparticles arranged in each of the arrangement portions is not particularly limited. The number of arranged semiconductor particles may be 3 or more, 7 or more, and, in some cases, 10 or more, or even 20 or more.

In the arrangement portions 21 to 24, a straight line passing through the semiconductor nanoparticles included in each of the arrangement portions can be drawn. In other words, each of the arrangement portions is arranged along an arrangement direction that is a straight line. Note that, in FIG. 2, only arrangement directions 33 and 34 of the respective arrangement portions 23 and 24 are shown, and other arrangement directions are omitted. Additionally, in the film cross section in FIG. 2, arrangement portions of semiconductor nanoparticles appear in addition to those shown in the figure, but are omitted for simplicity.

In the arrangement portions 23 and 24, the adjacent semiconductor nanoparticles 12 are apart from each other such that opposite sides thereof are substantially parallel to each other. In such arrangement portions, the average spacing between the adjacent semiconductor nanoparticles 12 can be easily held small. Gap portions of semiconductor nanoparticles are usually insulating, and accordingly an arrangement including semiconductor nanoparticles with small spacings therebetween is advantageous in achieving high conductivity. Furthermore, in the arrangement portions 23 and 24, the opposite sides of the adjacent semiconductor nanoparticles 12 are the long sides of rectangles. In such an arrangement structure in which the opposite sides are relatively long, even when the arrangement of the semiconductor nanoparticles 12 has a partial disorder, a portion where the semiconductor nanoparticles 12 are close to each other can be easily held, and accordingly the arrangement can be easily maintained over a long distance. This feature is also advantageous in achieving high conductivity.

The average spacing between the semiconductor nanoparticles is, for example, 10 nm or less, even 7 nm or less, and in some cases, 5 nm or less, 3 nm or less, or even 2 nm or less, and is particularly preferably 1.8 nm or less. The average spacing may be, for example, 0.3 nm or more or even 0.5 nm or more.

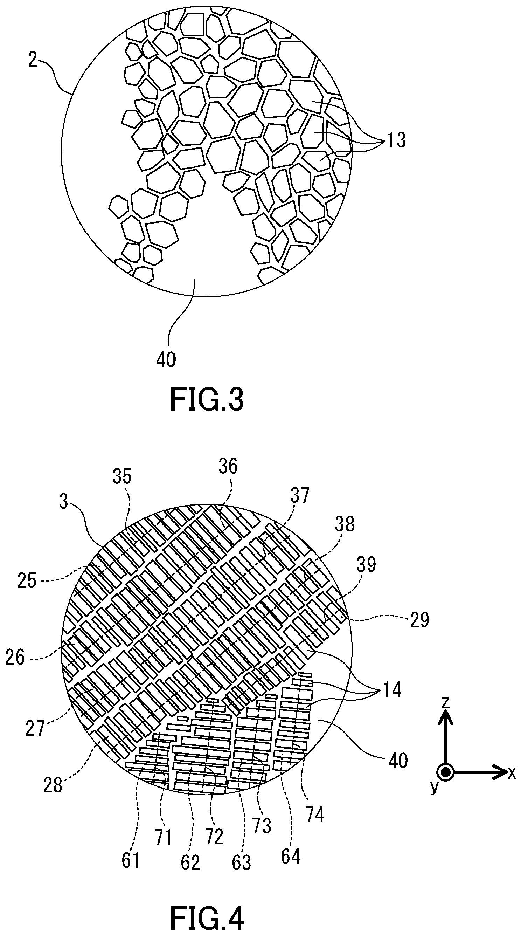

FIGS. 3 and 4 each show a cross section of another example of the conductive film. In a film cross section of a conductive film 2, only semiconductor nanoparticles 13 appear that are substantially pentagonal or hexagonal. Semiconductor nanoparticles appearing in a film cross section of a conductive film 3 are only semiconductor nanoparticles 14 that are rectangular. In FIG. 4, the semiconductor nanoparticles 14 that are rectangular are arranged in arrangement portions 25, 26, 27, 28, and 29 respectively extending along arrangement directions 35, 36, 37, 38, and 39 that are substantially parallel to each other. Furthermore, the semiconductor nanoparticles 14 that are substantially rectangular are arranged also in arrangement portions 61, 62, 63, and 64 respectively extending along arrangement directions 71, 72, 73, and 74 that are not substantially parallel to the arrangement directions 35 to 39, respectively, and are substantially parallel to each other. In the film cross section in FIG. 4, a large number of arrangement portions are present in which substantially rectangular semiconductor nanoparticles are arranged. In these arrangement portions, the semiconductor nanoparticles 14 are arranged, over a long distance, in line adjacent to and apart from each other such that opposite sides of the semiconductor nanoparticles are substantially parallel to each other. Such a film cross section is advantageous in sufficiently increasing the conductivity in the in-plane direction.

It should be noted that the conductive film 2 in which the film cross section (FIG. 3) in which the arrangement portion in which the rectangular semiconductor nanoparticles are arranged is not observed can also be observed in a different film cross section, for example, in a direction perpendicular to the drawing plane in FIG. 3. For example, a film in which the three-dimensional shape of the semiconductor nanoparticles 13 is a disc shape and the nanoparticles that are adjacent to each other in the height direction are arranged apart from each other such that the bottom surfaces thereof face each other can have a film cross section as shown in FIG. 4 depending on the cutting direction.

FIGS. 2 to 4 show the aspect in which all the semiconductor nanoparticles 11 to 14 are apart from each other. However, in the present embodiment, as long as an arrangement portion is included in which semiconductor nanoparticles arranged apart from each other, semiconductor nanoparticles may be partially in contact with each other in different portions. It should be also noted that even when semiconductor nanoparticles are actually apart from each other, the semiconductor nanoparticles can be observed to be in contact with other or to overlap each other depending on the direction of observation, the resolution of the equipment used for observation, and the like.

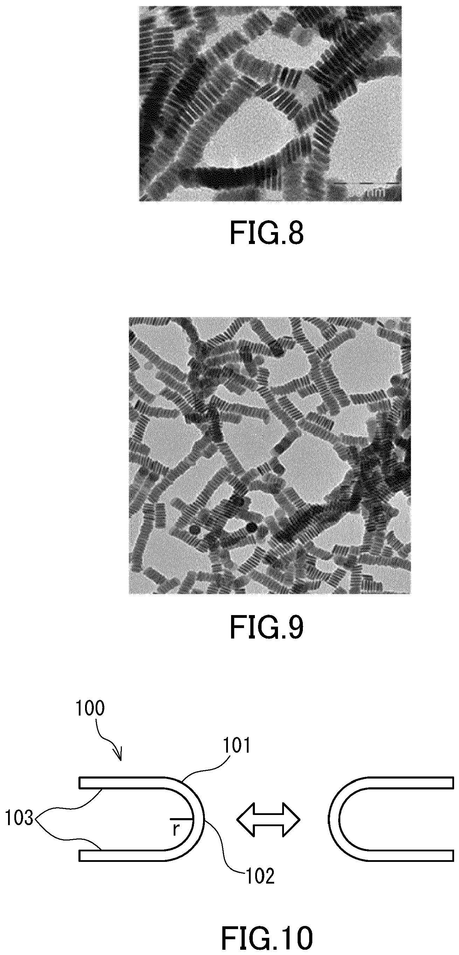

The arrangement state of the semiconductor nanoparticles in a region wider than those in FIGS. 2 to 4 is illustrated in FIGS. 8 and 9. As shown in these figures, the arrangement portions of the semiconductor nanoparticles do not need to extend in the same direction. Paths each constituted from a plurality of arrangement portions may be curved, bent, intersect each other, or partially overlap each other. The paths, which are each constituted from the plurality of arrangement portions, form a conductive path.

The conductive films 1 to 3 include the matrix 40 in which the semiconductor nanoparticles 11 to 14 are not present. The matrix 40 includes a binder and other material described later. The material such as the binder is also interposed between the semiconductor nanoparticles adjacent to each other in the arrangement portion. In addition, although all of the materials constituting the matrix 40 may be insulating, at least a portion of the materials may be conductive.

The matrix 40 constitutes an element permitting an autonomous arrangement of the semiconductor nanoparticles 11 to 14. An appropriate arrangement of the semiconductor nanoparticles 11 to 14 causes anisotropy in the conductivity of the conductive films 1 to 3, and can increase the conductivity to a practical level for at least a specific direction. The matrix 40 can also be an element contributing to an improvement in light transmittance of the conductive films 1 to 3. The matrix 40 can also be an element suppressing a decrease in conductivity of the conductive films 1 to 3 due to bending. In a cross section in which an arrangement portion including semiconductor nanoparticles that are arranged is observed, the matrix 40 in which semiconductor nanoparticles are not present may occupy 20% or more, 30% or more, even 40% or more, or 90% or less, or even 80% or less, of the entirety.

The conductive films 1 to 3 preferably include a compound adhering to the semiconductor nanoparticles 11 to 14. This compound can be interposed also between the semiconductor nanoparticles adjacent to each other in the arrangement portion. To keep the spacing between the semiconductor nanoparticles narrow, the compound preferably has a low molecular weight. Note that the compound adhering to the semiconductor nanoparticles can be removed or reduced after film formation by, for example, heating. Especially a compound having a low molecular weight, such as hydrazine, tends to disappear from the conductive film over time by so-called volatilization without intentional heating.

The conductivity C1 of the conductive film is 7 S/cm or more or even 10 S/cm or more, and is preferably 20 S/cm or more, more preferably 50 S/cm or more, still more preferably 100 S/cm or more, and particularly preferably 150 S/cm or more, and is 180 S/cm or more in some cases. The conductivity C1 only needs to be obtained by measuring along at least one direction. This direction may be the film surface direction parallel to the surface of the film, or may be the film thickness direction perpendicular to the surface of the film. In practice, high conductivity of a conductive film is often required for a specific direction. For example, in an extremely thin conductive film, the length in the film surface direction is much larger than the film thickness. Accordingly, an improvement in conductivity in the film surface direction substantially solves practical problems in many cases.

As can be understood from the above, the conductivity of the conductive films 1 to 3 can have anisotropy resulting from the arrangement state of the semiconductor nanoparticles. The conductive film according to the present embodiment may be a film in which the conductivity C1 is measured along the first direction and the conductivity C2 lower than the conductivity C1 is measured along the second direction. In the case where the first direction is the film surface direction, the second direction may be the film thickness direction. In the case where the first direction is the film thickness direction, the second direction may be the film surface direction.

The conductivity C2 may be, for example, less than 10%, less than 1%, even less than 0.1%, particularly less than 0.001%, or less than 0.0001% in some cases, of the conductivity C1. Note that by appropriately arranging the semiconductor nanoparticles or by narrowing the spacing between the semiconductor nanoparticles, it is possible to improve not only the conductivity C1 but also the conductivity C2. The conductivity C2 is, for example, 2 × 10⁻⁵ S/cm or more, even 1 × 10⁻⁴ S/cm or more, particularly 1 × 10⁻³ S/cm or more, and may be, in some cases, 1 × 10⁻² S/cm or more, even 1 × 10⁻¹ S/cm or more, or particularly 1 S/cm or more. Note that the conductive film of the present embodiment does not necessarily need to have a remarkable anisotropy in conductivity.

The disorder in the arrangement of the semiconductor nanoparticles hinders an achievement of the conductivity as high as the above. To prevent the disorder in the arrangement, it is for example desirable to sufficiently include, in a dispersion to be used as a conductive ink for conductive film formation, a compound that can adhere to the semiconductor nanoparticles. A film with a disordered arrangement of semiconductor nanoparticles tends to decrease not only in the conductivity C1 but also in the conductivity C2.

The directional dependence of the conductivity of the conductive film is affected at least by the affinity of the semiconductor nanoparticles for the surface of the base and by the three-dimensional shape of the semiconductor nanoparticles. For example, semiconductor nanoparticles whose three-dimensional shape is disc-shaped are arranged on a surface of a base having a low affinity for semiconductor nanoparticles, such that the disc surface is substantially perpendicular to the surface of the base. These semiconductor nanoparticles are arranged on a surface of a base having a high affinity for semiconductor nanoparticles, such that the disc surface is substantially parallel to the surface of the base. Furthermore, for example, semiconductor nanoparticles whose three-dimensional shape is a rod-shape are arranged on a surface of a base having a low affinity for semiconductor nanoparticles, such that the axial direction (long axis direction) of the rod is substantially perpendicular to the surface of the base, in other words, such that the rod stands on the surface. These semiconductor nanoparticles are arranged on a surface of a base having a high affinity for semiconductor nanoparticles, such that the axial direction of the rod is substantially parallel to the surface of the base, in other words, such that the rod lies on the surface.

To control the directional dependence of the conductivity of the conductive film through the arrangement of the semiconductor nanoparticles, the base to be used may be appropriately selected or the affinity of the surface of the base may be adjusted. For example, to arrange rod-shaped semiconductor nanoparticles on a surface of a base having a low affinity for semiconductor nanoparticles such that the long axis direction of the rod is substantially parallel to the surface, a material having a high affinity for semiconductor nanoparticles may be applied to the surface of the base in advance. This arrangement is suitable for formation of a conductive film having a relatively high conductivity C1 in the film thickness direction.

The light transmittance of the conductive film at a wavelength of 650 nm is, for example, 80% or more, even 85% or more, preferably 90% or more, and more preferably 92% or more. A conductive film having such a high light transmittance is called also a transparent conductive film. Note that the light transmittance of the conductive film at the same wavelength may be approximately 50 to 80%, and a light transmittance of 60% or more is sometimes sufficient depending on the use application. Furthermore, the light transmittance of the conductive film in the visible light region (region at the wavelength of 400 to 800 nm) is preferably, for example, 50% or more over the entire conductive film. This can achieve a conductive film that is almost transparent.

Similarly, the light transmittance of the conductive film at a wavelength of 550 nm is, for example, 80% or more, even 85% or more, preferably 90% or more, and more preferably 92% or more. The light transmittance of the conductive film at the same wavelength may be approximately 50 to 80%, and a light transmittance of 60% or more is sometimes sufficient depending on the use application.

The film thickness of the conductive film is not particularly limited, and may be appropriately set depending on the use application. The film thickness is, for example, 5 to 5000 nm, 5 to 2000 nm, even 10 to 1000 nm, or particularly 100 to 800 nm.

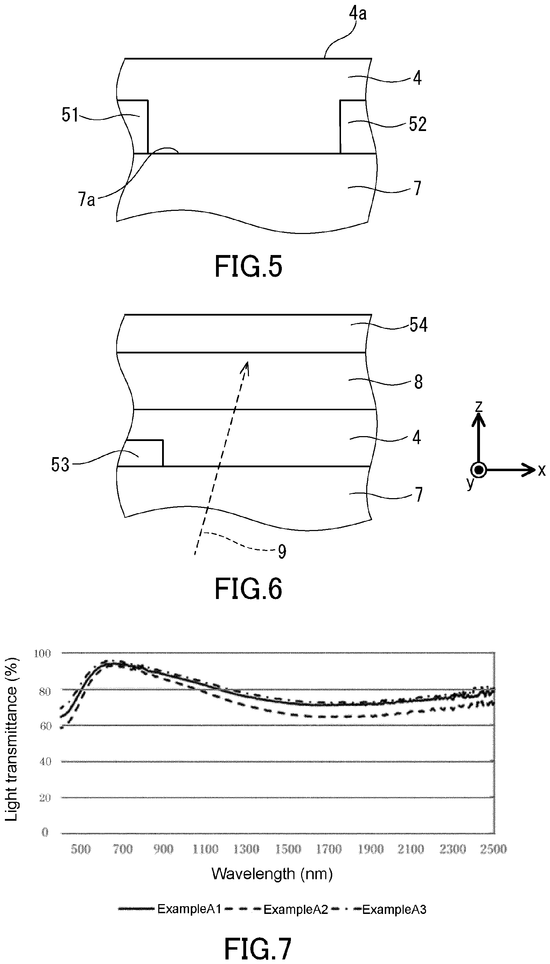

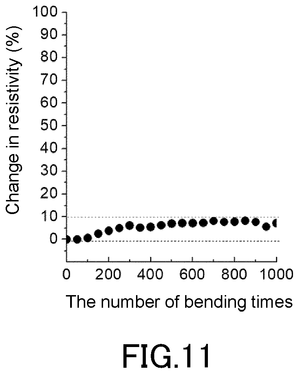

The conductivity of the conductive film of the present embodiment can have excellent folding resistance. Conventional conductive films, in which a conductive path is formed of conductive elements in contact with each other, have a conductivity that is likely to decrease due to bending. For example, a conductive film including silver nanowires in contact with each other as disclosed in FIG. 7 of Non Patent Literature 1 has a conductivity that often decreases significantly after bending approximately 300 to 400 times. In contrast, in the conductive film of the present embodiment, since the semiconductor nanoparticles, serving as conductive elements, which are apart from each other, form a conductive path, the conductivity is unlikely to decrease even after bending is repeated. As described later, an example of the conductive film of the present embodiment exhibits a result that the conductivity does not significantly decrease even after bending is repeated several hundred times or more, or even 1000 times (see FIG. 11). To prevent, to this degree, a decrease in conductivity of the conductive film including silver nanowires, the silver nanowires need to be melted by photonic curing for integration. As shown in FIG. 7 of Non Patent Literature 1, even when being subjected photonic curing, silver nanowires rapidly decrease in conductivity after being bent approximately 900 times or more. Making use of excellent folding resistance, the conductive film of the present embodiment is suitable for use in flexible devices.

When being subjected to the following bending test, the conductive film of the present embodiment can have a rate of change in resistance of 30% or less, even 20% or less, and particularly 10% or less, calculated based on a resistivity R1 before the test and a resistivity R2 after the test by (|R2 - R1|/R1) × 100. Note that the bending test is a test in which the following set is counted as one time and is repeated 500 times, or if necessary, 800 times or even 1000 times. In the set, a test piece with the conductive film formed thereon is bent such that a bent portion has a curvature radius of 5 cm or less at a bending angle of 180°, and is further bent oppositely in the same manner as above. The curvature radius may be usually set to 5 cm. However, in the case where the test piece is bendable to smaller, the curvature radius may be set to less than 5 cm, for example 1 cm, and in some cases 5 mm, in a more rigorous bending test. In addition, the resistivity R1 for use in the measurement is desirably 7 S/cm or more in terms of conductivity.

As shown in FIG. 10, a test piece 100 is bent one time for each side per one bending test. A curvature radius r of a bent portion 101 is defined at a deepest portion 102 of the bent portion 101. End portions 103 of the test piece 100 in a bent state are held parallel to each other such that the bending angle is 180°.

The conductive film of the present embodiment can have excellent weather resistance. For example, in a conductive film including silver nanowires as conductive elements, oxidation or migration progresses, resulting in a rapid decrease in conductivity in an environment of high temperature and humidity, unless the conductive film is coated with an overcoat. In contrast, since the conductive film of the present embodiment uses semiconductor nanoparticles as conductive elements, its conductivity is less likely to be affected even in the state where the surface of the film is exposed to an atmosphere of high temperature and humidity.

### <Components of Conductive Film>

### (Semiconductor Nanoparticles)

The semiconductor nanoparticles preferably include a compound semiconductor, specifically at least one selected from an oxide, a sulfide, a selenide, and a telluride. The semiconductor nanoparticles may be formed of a metal-compound semiconductor. In addition, a minor component, particularly a component for improving the conductivity, called a dopant, may be added to the semiconductor nanoparticles.

Examples of preferred oxides include indium oxide, zinc oxide, tungsten oxide, molybdenum oxide, cadmium oxide, copper oxide, vanadium oxide, and copper gallium oxide. Examples of preferred sulfides include copper sulfide and copper indium sulfide. Examples of preferred selenides include copper selenide. Examples of preferred tellurides include copper telluride.

The semiconductor nanoparticles may be crystalline or amorphous. However, in the case where the nanoparticles include crystals, the crystal structure thereof might affect the conductivity thereof. In addition, the type of crystal can affect even the three-dimensional shape of the semiconductor nanoparticles. Although a preferred crystal structure differs depending on the type of semiconductor nanoparticles, for example, copper sulfide preferably includes at least one selected from the group consisting of covellite, anilite, roxybite, digenite, and djuleite, and particularly preferably includes covellite and/or roxybite. The nanoparticles including copper sulfide may include only at least one crystal selected from the above.

The semiconductor nanoparticles preferably have a three-dimensional shape that results in a locally ordered structure by an autonomous arrangement. This three-dimensional shape is specifically a shape having a cross section in which substantially parallel opposite sides appear, and is typically a columnar body and/or a polyhedron. An example of the three-dimensional shape is a columnar body whose bottom surface is a circle, an ellipse, a polygon, or a shape that can be approximated to any one of these. This shape may be the rod shape or the disc shape described above.

The content of the semiconductor nanoparticles in the conductive film is not particularly limited, and is, for example, 5 to 98%, even 10 to 50%, and preferably 20 to 40%, as expressed by mass%.

### (Binder)

The conductive film may include a binder together with the semiconductor nanoparticles. The binder is a preferred component that can impart flexibility to the conductive film by being interposed between the semiconductor nanoparticles. The binder can also contribute to an improvement in film forming properties of the conductive film, an appropriate arrangement of nanoparticles, and the like.

The binder preferably includes an adhered compound adhering to the semiconductor nanoparticles. The adhered compound may include a functional group that can bond to the semiconductor nanoparticles, for example, at least one selected from fluoride (F), chloride (CI), bromide (Br), iodide (I), cyanide (CN), thiocyanate (SCN), isothiocyanate (NCS), hydroxide (OH), mercapto (SH), carbonyl (CO), amino (NR₃), nitrosyl (NO), nitrito (NO₂), phosphane (PR₃), carbene (R₂C), and pyridine (NC₅H₅). Here, each R is independently an organic residue or a hydrogen atom. As can be understood from the above examples, the functional group that can bond to the semiconductor nanoparticles may be other functional group that can function as a ligand to a metal atom or an anion.

The adhered compound may be an inorganic compound or an organic compound. In addition, the adhered compound may be a salt formed of an ion including the functional group exemplified above or consisting of the functional group and a counter ion thereof. The adhered compound may be a compound having a plurality of the functional groups described above, typified by hydrazine (H₂NNH₂), ethylenediamine (H₂NCH₂CH₂NH₂), ethylenedithiol (HSCH₂CH₂SH), mercaptopropionic acid (HSCH₂CH₂COOH), acetylacetonate (H₃CCOCHCOCH₃), aminobenzonitrile (NH₂C₆H₄CN), and the like.

The molecular weight of the adhered compound is, for example, 300 or less, and is preferably 200 or less, more preferably 100 or less, still more preferably 80 or less, and is less than 60 in some cases. The lower limit of the molecular weight is not particularly limited, and is, for example, 20 or more or even 30 or more. Using an adhered compound having a molecular weight that is not excessively high is suitable for controlling the spacing between semiconductor nanoparticles to be narrow.

The content of the adhered compound in the conductive film may be appropriately adjusted depending on the type thereof. The content may be, for example, 1% or more, even 2% or more, particularly 3% or more, and in some cases, 5% or more, and preferably 8% or more, as expressed by proportion of the mass of the adhered compound to the sum amount of the semiconductor nanoparticles and the adhered compound. The upper limit of this content is not particularly limited, but is 30% or less or even 20% or less.

As the binder, materials other than the above-described adhered compounds may be used. Examples of such compounds include various resins, specifically, polyvinyl alcohol, polyvinyl acetal, polyvinyl pyrrolidone, carboxymethyl cellulose, acrylic resin, polyvinyl acetate, polyethylene terephthalate, polystyrene, and polyethylene. In addition, a pH adjuster, a colorant, a thickener, a surfactant, and the like can be used depending on the necessity in film formation of the conductive film, the use application, and the like.

### <Device>

The conductive film according to the present invention is suitable for use in various devices, particularly devices using light-transmissive conductive films. Examples of such devices include photovoltaic devices typified by solar cells, image display devices typified by liquid crystal displays and organic EL displays, heat generation devices typified by heated windshields, and electromagnetic shielding devices typified by electromagnetic shielding windows and heat shielding windows. In these devices, the conductive film is used as an electrode film, an antistatic film, a heat-generating film, an electromagnetic shielding film, or the like. By using the conductive film having high transparency for the above-described use applications, advantages can be obtained such as no interference with product design, no interference with information communication, and achievement in invisibility.

In the devices described above, at least one electrode is sometimes disposed so as to abut on the conductive film for energization or discharge of electric charges. FIGS. 5 and 6 show examples of electrode disposition. In the example shown in FIG. 5, a pair of electrodes 51 and 52 are disposed apart from each other in the film surface direction of the conductive film 4. By applying a potential difference to the electrodes 51 and 52, an electric current flows in the film surface direction of the conductive film 4. This conductive film can function, for example, as a heat-generating film. The electrodes 51 and 52 do not need to be formed on the surface 7a of the base 7, and may be formed on the surface 4a of the conductive film 4. In addition, to discharge electric charges from the conductive film not for heat generation but for charge prevention or the like, only one electrode is necessary.

In the example shown in FIG. 6, the conductive film 4 abutting on an electrode 53 is used as a light-transmissive electrode. For example, when light 9 transmitted through the conductive film 4 enters a functional film 8, a potential difference is generated between the electrodes 53 and 54 due to the photoelectric conversion function of the functional film 8. In another device, when a potential difference is applied between the conductive film 4 and the electrode 54, a voltage is applied to the functional film 8 along its film thickness direction (z direction in FIG. 6). This causes the functional film 8 to emit light traveling toward a direction opposite to a direction in which the incident light 9 travels. In the example in FIG. 6, a transparent substrate such as a glass substrate or a transparent resin substrate can be used as the base 7, and a metal film such as an aluminum film can be used as the electrode 54. However, the base 7 and the electrode 54 are not limited to these examples. For example, the base 7 may be a substrate having a thin film on its surface.

In the aspect shown in FIG. 6, the electrode 53 extends along a direction perpendicular to the drawing plane (y direction in FIG. 6). In this case, to reduce the difference in potential in the conductive film 4 resulting from the distance from the electrode 53, the conductive film 4 preferably has a high conductivity C1 at least for the film surface direction (x direction) perpendicular to the direction in which the electrode extends.

In the aspect shown in FIG. 6, when observed from the z direction perpendicular to the film surface of the conductive film 4, an area S1 of a region in which the electrode 53 and the conductive film 4 overlap each other is less than 1/2, that is, less than 50% of an area S2 of the conductive film 4. The proportion of the area S1 to the area S2 may be, for example, 30% or less, even 20% or less, and in some cases, 10% or less.

However, the shape and disposition of the electrodes in the device are not limited to the examples in FIGS. 5 and 6.

To make use of the excellent folding resistance of the conductive film, a flexible device is also provided from the present embodiment. Although the flexible device, for example, further includes a base supporting the conductive film, the flexible device is bendable without being damaged such that a bent portion has a curvature radius of 5 cm or less, for example 1 cm, and in some cases 5 mm, at a bending angle of 180°. For such a device, a flexible base is suitable such as a woven fabric, a non-woven fabric, a paper, and a film, for example. In the device of the present embodiment, the conductive film can have a rate of change in resistance of 30% or less, even 20% or less, or particularly 10% or less, measured by the above-described bending test. However, the device of the present embodiment may be a rigid device lacking flexibility.

As described above, in the present embodiment, the conductive film can have excellent durability. To utilize this characteristic, in the device of the present embodiment, the conductive film may be at least partially exposed.

### <Dispersion>

A dispersion for use in conductive film formation is called also a conductive ink. In accordance with this convention, a dispersion is hereafter referred to also as a conductive ink herein. As can be understood from the above, a conductive ink itself is not required to have conductivity. A dispersion, which is a conductive ink, includes a dispersion medium, semiconductor nanoparticles dispersed in the dispersion medium, and a first compound. The first compound is present as an adhered compound adhering to the semiconductor nanoparticles and a free compound freed from the semiconductor nanoparticles. The dispersion satisfies at least one selected from the following i) to iv). It is desirable that the dispersion satisfies at least i). The dispersion may satisfy all of i) to iv):
i) The ratio of the amount of the first compound present as the free compound to the amount of the first compound present as the adhered compound is 1 or more;
ii) The proportion of the amount of the first compound to the sum of amounts of the semiconductor nanoparticles and the first compound is 10% or more in terms of mass;
iii) The semiconductor nanoparticles include at least one selected from an oxide, a sulfide, a selenide, and a telluride; and
iv) The semiconductor nanoparticles are each a columnar body and/or a polyhedron.

The conductive ink includes a dispersion medium, semiconductor nanoparticles dispersed in the dispersion medium, and the first compound. A portion of the first compound is included in the conductive ink as an adhered compound adhering to the semiconductor nanoparticles, whereas a remainder of the first compound is included in the conductive ink as a free compound freed from the semiconductor nanoparticles. The first compound may be the same as the second compound that is to adhere to the semiconductor nanoparticles in the conductive film, but is preferably a different compound from the second compound. This is because a compound desired for improving the conductivity in the conductive film does not necessarily match a compound desired for forming a conductive film including semiconductor nanoparticles that are appropriately arranged from the conductive ink. As the first compound, a compound can be used that is suitable for stable dispersion of semiconductor nanoparticles in the ink and for autonomous arrangement of the semiconductor nanoparticles in film formation of the conductive film formation. The second compound can be substituted for the first compound so as to be introduced into the conductive film after the film formation.

Autonomous arrangement of the semiconductor nanoparticles can be achieved by using, as a driving force, an interaction between the semiconductor nanoparticles, specifically, an electrostatic force, a van der Waals force, a dipole force, a dispersion force, and the like acting between the semiconductor nanoparticles. By using these as the driving force, as the dispersion medium is removed from the applied ink, it is possible to arrange the semiconductor nanoparticles in a self-controlled manner with the first compound interposed therebetween.

Similarly to the second compound already described as the adhered compound, the first compound that may be used is an inorganic or organic compound, particularly an organic compound including at least one of the functional groups exemplified above or two or more of the functional groups in some cases. Note that the first compound preferably has a higher molecular weight than the second compound. The molecular weight of the first compound is preferably 2000 or less, more preferably 1000 or less, and still more preferably 500 or less, and is for example, 60 to 300. When the first compound is a salt, the molecular weight of the first compound is also calculated based on the above-described method.

The content of the first compound in the conductive ink may be appropriately adjusted depending on the type thereof. The content, as expressed by proportion of the mass of the first compound to the sum mass of the semiconductor nanoparticles and the first compound, is preferably 10% or more, 15% or more, 16% or more, 17% or more, particularly preferably 18% or more, and in some cases, may be 20% or more, 25% or more, 28% or more, or particularly 30% or more. The upper limit of this proportion is not particularly limited, and is, for example, 90% or less, may be 86% or less, or may be 75% or less in some cases. To autonomously and appropriately arrange the semiconductor nanoparticles in the film after film formation, it is preferable to add the first compound in a larger amount than in the case where the purpose is only to maintain the semiconductor nanoparticles stably dispersed in the ink. A conductive film formed from a conductive ink insufficiently including the first compound often has insufficient conductivity.

To appropriately arrange the semiconductor nanoparticles, the conductive ink desirably includes an appropriate amount of the first compound as a free compound. When the amount of the free compound is less than an appropriate range, it is considered that the semiconductor nanoparticles may be very partially aggregated even if the dispersion state can be secured in the conductive ink. This aggregation can be a factor inhibiting an appropriate arrangement of the semiconductor nanoparticles in the conductive film. The first compound is usually relatively more stable in the state adhering to the semiconductor nanoparticles than in the free state. Accordingly, the range of an appropriate amount of the free compound can be represented by a ratio, specifically a mass ratio or a molar ratio, to the adhered compound. The ratio of the amount of the first compound included as the free compound to the amount of the first compound included as the adhered compound is preferably 1 or more, 2 or more, 3 or more, 4 or more, 5 or more, 6 or more, 7 or more, and particularly preferably 8 or more, and may be 10 or more in some cases. The upper limit of this ratio is not particularly limited, and is, for example, 100 or less, and may be 50 or less or even 30 or less, and in some cases, may be 28 or less or even 27 or less.

The dispersion of the semiconductor nanoparticles sometimes includes an impurity derived from a raw material for synthesis of the semiconductor nanoparticles, an additive added for the synthesis, and the like. The impurity is typically an unreacted raw material. To remove the impurity, a solvent may be added and the impurity may be removed together with the solvent. As such a solvent, a polar solvent, particularly a polar organic solvent may be used. As described later, a nonpolar organic solvent or a polar organic solvent having a low polarity is usually used as the dispersion medium. Impurity removal can be performed, for example, by a method including the following steps.

- Addition of solvent: A step of mixing a starting liquid and a solvent to obtain a liquid mixture, the starting liquid including a dispersion medium, semiconductor nanoparticles dispersed in the dispersion medium, the first compound, and an impurity
- Application of centrifugal operation: A step of applying a centrifugal operation at a predetermined rotation speed to the liquid mixture
- Removal of solvent: A step of removing, after the centrifugal operation, the above solvent together with at least a portion of the impurity from the above liquid mixture

An excessively high rotation speed of the centrifugal operation increases the amount of the first compound to be removed together with the solvent. For this reason, the rotation speed of the centrifugal operation is preferably less than 5000 rpm, particularly preferably in the range from 500 to 4000 rpm. For the similar reason, the centrifugal operation is performed preferably in a temperature of the liquid mixture near normal temperature, specifically in the range from 10 to 30°C. In addition, a suitable polar solvent is a poor solvent for semiconductor nanoparticles. A polar solvent having a polarity higher than the dispersion medium is suitable as the polar solvent, in the case where the dispersion medium also is a polar solvent. As the polar solvent, specifically, a low-boiling point solvent, for example, water, or a polar organic solvent having 1 to 4 carbon atoms such as an alcohol or acetone, is suitable. Furthermore, the number of application times of the centrifugal operation is not particularly limited, and two to three times is preferred in general.

Separately from the above-described conductive ink (referred to also as "first ink" when set with a second ink described later), an ink is desirably prepared that includes the second compound to be substituted for the first compound (hereinafter referred to also as "second ink"). An ink set including the first ink and the second ink is convenient for film formation of a conductive film. The ink set includes, for example, a first ink, a first container containing the first ink, a second ink, and a second container containing the second ink. As described above, the first compound and the second compound are a combination of compounds in which the latter has a lower molecular weight than the former.

The conductive ink (first ink) and the second ink may include a pH adjuster, a co-solvent, and other component. The other component may be the above-described component that can be included in the conductive film, or may be a volatile component that does not remain in the conductive film.

Preferred aspects of the shape, the crystal, and the like of the semiconductor nanoparticles are as described above. The content of the semiconductor nanoparticles in the conductive ink (first ink) is not particularly limited, and is, for example, 1 to 70%, even 5 to 50%, and preferably 10 to 20%, as expressed by mass%. The dispersion medium in the conductive ink (first ink) is not particularly limited as long as it can disperse the semiconductor nanoparticles. For example, an organic solvent is preferred, such as toluene, hexane, octane, and chloroform. The solvent for the second ink is also not particularly limited as long as it can dissolve the second compound. A solvent depending on the type of the second compound may be used.

### <Method for Manufacturing Conductive Film>

A method for manufacturing the conductive film according to the present embodiment includes the following first step and second step in this order. After performing the second step, the following third step and fourth step may be performed. In the case where the film thickness does not reach a desired value, the third step and the fourth step can be performed repeatedly two or more times. In the case where the above-described ink set is used, the first ink is used as a conductive ink and the second ink is used as a solution including the second compound.

### (First Step)

In the first step, a conductive ink including semiconductor nanoparticles and the first compound is applied to a surface of a base to form a coating film.

### (Second Step)

In the second step, a solution including the second compound is brought into contact with the coating film formed in the first step to substitute the second compound for at least a portion of the first compound thus to obtain a conductive film.

### (Third Step)

In the third step, the conductive ink is applied to a surface of the formed conductive film to form an additional coating film.

### (Fourth Step)

In the fourth step, the solution including the second compound is brought into contact with the additional coating film formed in the third step to substitute the second compound for at least a portion of the first compound included in the formed additional coating film thus to obtain a conductive film having an increased film thickness.

The application of the conductive ink or the solution in each of the steps can be performed by a known coating method, such as spin coating, roll coating, flow coating, or dip coating.

Hereinafter, the present invention will be further described by way of examples. The following description is also not intended to limit the present invention to specific examples.

### (Example A1)

### • Production of Conductive Ink

Into a three-neck flask, 1.891 g of copper acetate, 1.13 g of 1,3-dibutyl-2-thiourea, and 10 ml of oleylamine were put, and were subjected to nitrogen substitution while being stirred. Next, the liquid temperature was raised to 80°C using a heating mantle, and was held for 1 hour. Then, at a stage when the liquid temperature lowered to 40°C, 40 ml of chloroform was gradually added to the three-neck flask to dissolve the solids.

The contents in the three-neck flask were transferred to a centrifuge tube, and after observation of a sufficient dissolution of the solid matter in the centrifuge tube, 40 ml of ethanol was put. Further, a centrifugal operation was performed under the conditions at 2000 rpm (rotation/minute) for 10 minutes, and a supernatant liquid was discarded immediately. Subsequently, a precipitate was dissolved in 5 ml of octane, and then 30 ml of ethanol was further put. A centrifugal operation was further performed at the rotation speed of 2000 rpm for 5 minutes to collect a precipitate. The mass of the precipitate was measured, and based on this, octane was added to 200 mg/ml to obtain a conductive ink where copper sulfide nanoparticles were dispersed.

The conductive ink included, together with the copper sulfide nanoparticles, oleylamine, which is a compound that can coordinate to the copper sulfide nanoparticles. As a result of analysis of the above precipitate by thermogravimetric analysis (TGA), the proportion of the mass of oleylamine to the sum mass of the copper sulfide nanoparticles and oleylamine was 10%. Note that this proportion was the same also in subsequent examples.

### • Formation of Conductive Film

Onto a glass substrate on which an interdigitated electrode has been formed in advance, 50 µl of the conductive ink (first ink) was applied using a spin coater to obtain a coating film. In the application, the concentration of the conductive ink was adjusted to 50 mg/ml. Used as the glass substrate with the interdigitated electrode formed thereon was a commercially available product (G-IDEU5 manufactured by DropSens) that has an electrode width and an electrode interval of 5 µm or 10 µm, a pair number of 250 (for the electrode width of 5 µm) or 125 (for the electrode width of 10 µm), and a beam length of 6760 µm.

Onto the coating film, 200 µl of a solution (second ink) including KSCN to be an adhered compound was applied using a spin coater thus to obtain a conductive film. The solvent for this solution was octane, and the concentration of KSCN was set to 10 mass%. The compound coordinated to the copper sulfide nanoparticles was brought into contact with the second ink, and accordingly in at least a portion of the compound, oleylamine (first compound) was substituted with KSCN (second compound).

On the conductive film, an additional coating film was formed by the same film formation as the above using the first ink. Then, compound substitution was performed using the second ink in the same manner as the above. Thus, a conductive film having an increased film thickness was obtained.

### (Examples A2 to A4)

A conductive film was produced in the same manner as that in Example A1, except that the second compound in the second ink to be an adhered compound was set to the compound shown in Table 1. At this time, the number of application repetition times n for film thickness increase (n = 2 in Example A1) was also set to the number of times shown in Table 1.

### (Examples A5 to A8)

### • Production of Conductive Ink

Into a three-neck flask A, 0.246 g of copper acetate and 20 ml of oleylamine were put, and evacuation was performed while performing stirring. Next, the flask A was heated using an oil bath to raise the liquid temperature to 160°C, and the flask A in this state was held for 1 hour. The rate of temperature rise was set to 8°C/min. On the other hand, 0.096 g of sulfur and 30 ml of 1-octadecene were put into another three-neck flask B, and evacuation and atmosphere substitution with a nitrogen gas were repeated while performing stirring. Then, the nitrogen gas was allowed to flow in to hold a nitrogen gas atmosphere. Next, the flask B was heated to raise the liquid temperature to 160°C using an oil bath to dissolve sulfur. The rate of temperature rise was set to 5°C/min. After the flask B was left for 1 hour, a nitrogen gas was allowed to flow in to hold a nitrogen gas atmosphere.

The contents in the flask A were transferred to a centrifuge tube, and the contents in the flask B were put into the centrifuge tube using a syringe, and were held for 10 minutes. Subsequently, after the heater was turned off and the liquid temperature lowered to 40°C, approximately 30 ml of hexane was put into the centrifuge tube. Next, after visual observation of dissolution of the resultant solid matter, 30 ml of ethanol was put, a centrifugal operation was performed at the rotation speed of 2000 rpm for 5 minutes to collect a precipitate. Subsequently, the precipitate was dissolved in 5 ml of octane, and then 30 ml of ethanol was further put. A centrifugal operation was further performed at the rotation speed of 2000 rpm for 5 minutes to collect a precipitate. The mass of the precipitate was measured, and based on this, octane was added to 200 mg/ml to obtain a conductive ink where copper sulfide nanoparticles were dispersed.

### • Formation of Conductive Film

A conductive film was produced in the same manner as that in Example A1, except that the second compound in the second ink to be an adhered compound was set to the compound shown in Table 1. At this time, the number of application repetition times n for film thickness increase was also set to the number of times shown in Table 1.

### (Example A9)

Into a three-neck flask, 50.5 mg of copper chloride (CuCl₂), 271.8 mg of copper nitrate (Cu(NO₃)₂/3H₂O), 2.46 ml of oleylamine, 15 ml of 1-octadecene, and 6 ml of dodecanethiol were put. Evacuation and substitution with a nitrogen gas were repeated while performing stirring, and evacuation was performed finally. Next, the three-neck flask was heated using a heating mantle to raise the liquid temperature to 100°C, and the three-neck flask in this state was held for 30 minutes. Subsequently, while raising the liquid temperature to 180°C, 10 ml of t-dodecanethiol was injected with a syringe, and the three-neck flask was held at 180°C for 5 minutes, and then was rapidly cooled with tap water.

The contents in the three-neck flask were transferred to a centrifuge tube, and approximately 30 ml of hexane was put into the centrifuge tube. Next, after visual observation of dissolution of the resultant solid matter, 15 ml of isopropanol and 15 ml of acetone were put, and a centrifugal operation was performed at the rotation speed of 2000 rpm for 5 minutes to collect a precipitate. Subsequently, the precipitate was dissolved in 5 ml of octane, and then 30 ml of ethanol was further put. A centrifugal operation was further performed at the rotation speed of 2000 rpm for 5 minutes to collect a precipitate. The mass of the precipitate was measured, and based on this, octane was added to 200 mg/ml to obtain a conductive ink where copper sulfide nanoparticles were dispersed. After the liquid temperature lowered to 40°C, approximately 30 ml of hexane was put into the centrifuge tube. Next, after visual observation of dissolution of the resultant solid matter, 30 ml of ethanol was put, and a centrifugal operation was performed at the rotation speed of 2000 rpm for 5 minutes to collect a precipitate. Subsequently, the precipitate was dissolved in 5 ml of octane, and then 30 ml of ethanol was further put. A centrifugal operation was further performed at the rotation speed of 2000 rpm for 5 minutes to collect a precipitate. The mass of the precipitate was measured, and based on this, octane was added to 200 mg/ml to obtain a conductive ink where copper sulfide nanoparticles were dispersed.

### • Formation of Conductive Film

A conductive film was produced in the same manner as that in Example A1, except that the second compound in the second ink to be an adhered compound was set to the compound shown in Table 1. At this time, the number of application repetition times n for film thickness increase was also set the number of times shown in Table 1.

For the obtained conductive films, the conductivity and the film thickness were measured, and further the crystal system of copper sulfide included in the copper sulfide nanoparticles was measured by X-ray diffraction. Furthermore, for Examples A1 to A3, the light transmittance was also measured. The results are shown in Table 1 and FIG. 7. The light transmittance in Table 1 indicates the values at a wavelength of 650 nm.

**[Table 1]**

| Example | Nanoparticles | | | Adhered compound (Molecular weight) | n | Film thickness nm | Conductivity S/cm | Transmittance % |
|---|---|---|---|---|---|---|---|---|
| | Composition | Crystal | Shape | | | | | |
| A1 | Cu_{1.75}S | R | d | KSCN (58.1) | 2 | 15 | 146.3 | 94 |
| A2 | Cu_{1.75}S | R | d | Hvdrazine (32.1) | 2 | 18 | 193.7 | 93 |
| A3 | Cu_{1.75}S | R | d | MPA (106.1) | 2 | 9 | 194.2 | 95 |
| A4 | Cu_{1.75}S | R | d | BT (110.2) | 2 | 50 | 50.3 | - |
| A5 | CuS | c | d | EDT (94.2) | 5 | 30 | 44.3 | - |
| A6 | CuS | c | d | Hydrazine (32.1) | 10 | 42 | 373.7 | - |
| A7 | CuS | c | d | EDA (60.1) | 10 | 42 | 36.8 | - |
| A8 | CuS | c | d | ABN (118.1) | 5 | 30 | 11.2 | - |
| A9 | CuS | c | r | EDT (94.2) | 5 | 400 | 7.4 | - |

| | | | | | | | | |
|---|---|---|---|---|---|---|---|---|
| • R: roxybite, C: covellite • d: disc shape, r: rod shape • KSCN: potassium thiocyanate (molecular weight for only SCN), MPA: mercaptopropionic acid, BT: benzenethiol, EDT: ethylenedithiol, EDA: ethylenediamine, ABN: aminobenzonitrile | | | | | | | | |

On a surface of a glass substrate with an ITO film, a conductive film was produced in the same manner as that in Example A5, and a gold electrode was vapor-deposited partially on a surface of the conductive film. The conductivity measured for this conductive film in the film thickness direction was 9 × 10⁻⁵ S/cm. Also for the conductive films obtained from other examples, it was ascertained that the conductivity in the film thickness direction was lower than the conductivity in the film surface direction measured using an interdigitated electrode, and was much lower than 1%. Also for the other examples, in view of the arrangement of nanoparticles, the conductivity in the film thickness direction was considerably lower than the conductivity in the film surface direction, and is not considered to exceed 10%.

As a result of observation using a TEM, it was ascertained that the nanoparticles produced in Example A9 had a rod-shape and were arranged such that the long axis direction thereof faced in a direction perpendicular to the surface of the base. On the other hand, it was observed that the nanoparticles produced in Examples A1 to A8 had a disc-shape and were arranged such that the disc surface faced in a direction perpendicular to the surface of the base. These crystal particles had substantially rectangular cross sections, and were arranged close to each other such that opposite long sides thereof were substantially parallel to each other. Furthermore, it was also ascertained that the arrangement direction of this arrangement extended in the film surface direction. Moreover, in all of the examples, the average spacing between the copper sulfide nanoparticles was 10 nm or less. For example, in the case where a conductive film was produced in the same manner as that in Example A5 on a surface of a glass substrate with an interdigitated electrode formed thereon, the average spacing between copper sulfide nanoparticles after substitution with EDT was 1.1 nm.

FIGS. 8 and 9 show the results obtained by observation using a TEM on a conductive film formed from a conductive ink obtained in the same manner as the above. FIGS. 8 and 9 are observation images of the film surface of the conductive film.

As is clear from Table 1, roxybite is a preferred crystal that can stably provide relatively high conductivity. To the best of the present inventor's knowledge, this point is a finding that has been conventionally unknown. Furthermore, covellite is a crystal that can provide remarkably improved conductivity especially when combined with a compound having a low molecular weight. In other words, the conductivity exhibited from covellite is susceptible to an adhered compound.

### (Example A10)

### • Formation of Conductive Film

A conductive film was produced on a borosilicate glass substrate in the same manner as that in Example A1, except that the second compound in the second ink to be an adhered compound was set to hydrazine. At this time, the number of application repetition times for film thickness increase was set to 15. Then, the conductive film was cut to have a size of 10 mm x 10 mm thus to produce a measurement sample. Then, an Au electrode having a thickness of 100 to 200 nm was provided at each of four corners of a surface of the measurement sample by vapor deposition. Then, four terminals were brought into contact with the respective Au electrodes formed at the four corners, and the sheet resistance of the measurement sample was measured by Van Der Pauw method using a sheet resistance measurement device, Resi Test8400 (manufactured by Toyo Corporation). As a result of the measurement, the sheet resistance, which is the resistance in the film surface direction, was 100 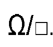 . In other words, a conductive film having a certain size close to practical use achieved performance almost equal to that of indium tin oxide (ITO). Unlike ITO that needs to be formed by vapor deposition, this conductive film can be formed by application, and accordingly can be more easily manufactured and was ascertained to have an advantage.

### (Example B1)

A conductive ink was obtained in the same manner as that in Example A5, except that octadecene was used instead of octane as an organic solvent to be finally put for obtaining the conductive ink. In this conductive ink, oleylamine is included as an adhered compound adhering to copper sulfide nanoparticles and as a free compound freed from the copper sulfide nanoparticles. The ratio of the free compound to the adhered compound in this conductive ink was calculated as follows.

Into a centrifuge tube, 5 ml of the conductive ink was put first, and then 45 ml of ethanol was put, and a centrifugal operation was performed under the conditions at 2000 rpm for 10 minutes. Next, evacuation was performed to remove a residual solvent from the resultant precipitate. The resultant dried solid was subjected to thermogravimetric analysis (TGA) to measure the respective amounts of copper sulfide nanoparticles constituting the precipitate and oleylamine adhering thereto (adhered compound). The proportion of the amount of oleylamine (adhered compound) to the sum amount of the copper sulfide nanoparticles and oleylamine (adhered compound) was 10% in terms of mass. On the other hand, from a supernatant liquid obtained by the centrifugal operation, only ethanol was removed using an evaporator, and based on the amount of the liquid after removal of ethanol and the ratio in put amount of oleylamine and octadecene, the amount of oleylamine freed from the copper sulfide nanoparticles (free compound) was calculated. Based on the above, the ratio of the amount of the free compound to the amount of the adhered compound was calculated to 21.4.

A conductive film was obtained in the same manner as that in Example A5, except that the conductive ink of Example B1 was used. Note that the film formation was performed such that the film thickness was 135 nm. The measured conductivity is shown in Table 2.

### (Example B2)

The conductive ink produced in Example A1 was subjected twice in total to the impurity removal step by the centrifugal operation. However, from the viewpoint of removing an impurity such as an unreacted compound, it is desirable to perform the centrifugal operation further repeatedly. In consideration of this, in Example B2, a centrifugal operation was applied twice under the same conditions as those in Example B1, and then a third-time centrifugal operation was performed under the same conditions as those in the second-time centrifugal operation. With use of a conductive ink obtained in the same manner as that in Example B1 except for this, the ratio of the free compound to the adhered compound was calculated in the same manner as that in Example B1, and a conductive film was formed to measure the conductivity. The results are shown in Table 2.

### (Comparative Example B3)

The conductive ink produced in Example A1 was subjected to the impurity removal step by the centrifugal operation under the conditions at the rotation speed of 2000 rpm. However, from the viewpoint of impurity removal, it is desirable to apply a centrifugal operation at a higher rotation speed as well. In consideration of this, in Comparative Example B3, the conditions for the centrifugal operation were changed to those at 8000 rpm for 2 minutes and the centrifugal operation was performed three times in total. In addition, the second-time and third-time washing were performed by putting a liquid mixture including chloroform and ethanol in the ratio of 1: 20. With use of a conductive ink obtained in the same manner as that in Example B1 except for this, the ratio of the free compound to the adhered compound was calculated in the same manner as that in Example B1, and a conductive film was formed to measure the conductivity. The results are shown in Table 2.

**[Table 2]**

| Example Comparative Example | Centrifugal operation (Rotation speed/ Time period/ The number of times) | Free compound/ Adhered compound | All compounds excluding particles/ (Particles + all compounds excluding particles) % | Film thickness nm | Conductivity S/cm |
|---|---|---|---|---|---|
| B1 | 2000 rpm/ 5 min/ 2 times | 21.4 | 71 | 135 | 12.2 |
| B2 | 2000 rpm/ 5 min/ 3 times | 15.1 | 64 | 135 | 10.1 |
| B3 | 8000 rpm/ 2 min/ 3 times | 0.11 | 11 | - | < 1 |

| | | | | | |
|---|---|---|---|---|---|
| • B3: comparative example • All compounds excluding particles: free compound + adhered compound | | | | | |

Also in the conductive films obtained in Examples B1 and B2 and Comparative Example B3, the conductivity in the film surface direction was higher than the conductivity in the film thickness direction. In addition, it is considered that, in Comparative Example B3, the semiconductor nanoparticles were partially aggregated in the conductive ink, and accordingly the arrangement of the semiconductor nanoparticles was locally lost or altered to different ones when viewed over the entire conductive film. Such a film cannot exhibit sufficient conductivity even in a direction in which the conductivity is relatively high (the film surface direction in the above example).

### (Example C1)

A conductive film was obtained in the same manner as that in Example A6, except that a PET substrate with an interdigitated electrode formed thereon was used instead of the glass substrate with the interdigitated electrode formed thereon and that the number of application times was set to five. As the PET substrate with the interdigitated electrode formed thereon, a commercially available product (DRIP-P-IDEAU100 manufactured by DropSens) was used. The PET substrate with the conductive film formed thereon was bent 1000 times as shown in FIG. 10 such that a bent portion had a curvature radius of approximately 5 mm. Bending in which the conductive film was on the inner side and bending in which the conductive film was on the outer side were successively performed. This set was counted as one time as the number of bending times. Furthermore, for every 50 bending times, the resistivity of the conductive film was measured using the interdigitated electrode. FIG. 11 shows the change in resistivity of the conductive film due to bending. The rate of change in resistivity was 10% or less.

### (Example D1)

A conductive film was obtained in the same manner as that in Example A6, except that anisidine (having a molecular weight of 123.2) was used as the second compound in the second ink to be an adhered compound. With this conductive film exposed, the resistance value was measured at the time of production and after elapse of one and a half years (13140 hours) or more from the time of production. As a result, no increase in resistivity of the conductive film was observed.

### (Example D2)

With the conductive film of Example A6 exposed, the resistance value was measured at the time of production and after elapse of one and a half years or more from the time of production. As a result, the resistance value, which was 44 Ω at the time of production, reached 78 Ω after one and a half years. Although the resistance value increased, it is considered that the increase in resistance value can be definitely suppressed as compared to silver nanowires with no overcoat.

## Claims

1. A conductive film comprising
an arrangement portion of semiconductor nanoparticles, wherein
the semiconductor nanoparticles are arranged in line apart from each other in the arrangement portion in a cross section of the conductive film, the cross section comprising the arrangement portion, and
a conductivity C1 measured along at least one direction is 7 S/cm or more.

2. The conductive film according to claim 1, wherein
in the arrangement portion in the cross section, the semiconductor nanoparticles that are adjacent to each other are apart from each other such that opposite sides of the adjacent semiconductor nanoparticles are substantially parallel to each other.

3. A conductive film comprising semiconductor nanoparticles as conductive elements, wherein
the conductive film exhibits an anisotropic conductivity in which a conductivity C1 measured along a first direction is 7 S/cm or more and a conductivity C2 measured along a second direction is less than 10% of the conductivity C1, and
one of the first direction and the second direction is a film surface direction, and the other is a film thickness direction.

4. The conductive film according to claim 3, wherein
the conductivity C2 is 2 × 10⁻⁵ S/cm or more.

5. The conductive film according to any one of claims 1 to 4, having a rate of change in resistance, when being subjected to a bending test, of 30% or less calculated based on a resistivity R1 before the test and a resistivity R2 after the test by (|R2 - R1|/R1) × 100,
where the bending test is a test in which the following set is counted as one time and is repeated 500 times,
in the set, a test piece with the conductive film formed thereon is bent in a manner such that a bent portion has a curvature radius of 5 cm or less at a bending angle of 180°, and is further bent oppositely in the same manner.

6. The conductive film according to any one of claims 1 to 5, wherein
a three-dimensional shape of the semiconductor nanoparticles is a columnar body and/or a polyhedron.

7. The conductive film according to any one of claims 1 to 6, wherein
the semiconductor nanoparticles include at least one selected from the group consisting of an oxide, a sulfide, a selenide, and a telluride.

8. The conductive film according to any one of claims 1 to 7, wherein
the semiconductor nanoparticles include copper sulfide.

9. The conductive film according to claim 8, wherein
the copper sulfide includes covellite and/or roxybite.

10. A dispersion comprising:
a dispersion medium;
semiconductor nanoparticles dispersed in the dispersion medium; and
a first compound, wherein
the first compound is present as an adhered compound and a free compound, the adhered compound adhering to the semiconductor nanoparticles, the free compound being freed from the semiconductor nanoparticles, and
the dispersion satisfies at least one selected from i) to iv):
i) a ratio of an amount of the first compound present as the free compound to an amount of the first compound present as the adhered compound is 1 or more;
ii) a proportion of an amount of the first compound to a sum of amounts of the semiconductor nanoparticles and the first compound is 10% or more in terms of mass;
iii) the semiconductor nanoparticles include at least one selected from an oxide, a sulfide, a selenide, and a telluride; and
iv) the semiconductor nanoparticles are each a columnar body and/or a polyhedron.

11. The dispersion according to claim 10, satisfying at least i).

12. The dispersion according to claim 11, satisfying all of i) to iv).

13. The dispersion according to any one of claims 10 to 12, wherein
in formation of a coating film by applying the dispersion to a base, the semiconductor nanoparticles are autonomously arranged to form, in a cross section of the coating film, an arrangement portion in which the semiconductor nanoparticles are arranged apart from each other.

14. The dispersion according to any one of claims 10 to 13, wherein
the semiconductor nanoparticles include copper sulfide.

15. The dispersion according to claim 14, wherein
the copper sulfide includes covellite and/or roxybite.

16. A method for manufacturing the dispersion according to any one of claims 10 to 15, the method comprising:
mixing a starting liquid and a solvent to obtain a liquid mixture, the starting liquid including a dispersion medium, semiconductor nanoparticles dispersed in the dispersion medium, a first compound, and an impurity;
applying a centrifugal operation to the liquid mixture at a rotation speed of less than 5000 rpm; and
removing, after the centrifugal operation, the solvent together with at least a portion of the impurity from the liquid mixture.

17. An ink set comprising:
a first ink being a dispersion and including a dispersion medium, semiconductor nanoparticles dispersed in the dispersion medium, and a first compound, the first compound being present as an adhered compound and a free compound, the adhered compound adhering to the semiconductor nanoparticles, the free compound being freed from the semiconductor nanoparticles; and
a second ink including a second compound having a lower molecular weight than the first compound, the second compound being adherable to the semiconductor nanoparticles as a substitution of the first compound.

18. The ink set according to claim 17, wherein
the molecular weight of the second compound is less than 60.

19. A device comprising the conductive film according to any one of claims 1 to 9, wherein
the device comprises the conductive film as at least one functional film selected from an electrode film, an antistatic film, a heat-generating film, and an electromagnetic shielding film.

20. A device comprising:
a conductive film including semiconductor nanoparticles; and
at least one electrode in contact with the conductive film, wherein
the conductive film satisfies the following a) and/or b):
a) the conductive film includes an arrangement portion of the semiconductor nanoparticles,
the semiconductor nanoparticles are arranged in line apart from each other in the arrangement portion in a cross section of the conductive film, the cross section comprising the arrangement portion, and
a conductivity C1 measured along at least one direction is 7 S/cm or more; and
b) the conductive film includes the semiconductor nanoparticles as conductive elements,
the conductive film exhibits an anisotropic conductivity in which a conductivity C1 measured along a first direction is 7 S/cm or more and a conductivity C2 measured along a second direction is less than 10% of the conductivity C1, and
one of the first direction and the second direction is a film surface direction, and the other is a film thickness direction.

21. The device according to claim 19 or 20, further comprising
a base supporting the conductive film, wherein
the base is bendable without being damaged such that a bent portion has a curvature radius of 5 cm or less at a bending angle of 180°.

22. A method for manufacturing a conductive film, the conductive film being the conductive film according to any one of claims 1 to 9, the method comprising:
a first step of applying a first ink to a surface of a base to form a coating film, the first ink being a dispersion and including a dispersion medium, semiconductor nanoparticles dispersed in the dispersion medium, and a first compound, the first compound being present as an adhered compound and a free compound, the adhered compound adhering to the semiconductor nanoparticles, the free compound being freed from the semiconductor nanoparticles; and
a second step of bringing, into contact with the coating film, a second ink including a second compound that is adherable to the semiconductor nanoparticles as a substitution of the first compound, to substitute the second compound for at least a portion of the first compound in the coating film, the second compound having a lower molecular weight than the first compound.
